Europäisches Patentamt

(19) **European Patent Office**

Office européen des brevets

(11) Publication number: **0 179 088**
**B1**

(12) **EUROPEAN PATENT SPECIFICATION**

(45) Date of publication of the patent specification:
24.08.88

(51) Int. Cl.⁴: **H 01 L 27/08, H 01 L 21/76, H 01 L 21/265**

(21) Application number: 85901694.1

(22) Date of filing: 28.02.85

(86) International application number:
**PCT/US 85/00347**

(87) International publication number:
**WO 85/04525 (10.10.85 Gazette 85/22)**

(54) A LATCH-UP RESISTANT CMOS STRUCTURE FOR VLSI.

(30) Priority: 29.03.84 US 594589

(43) Date of publication of application:
30.04.86 Bulletin 86/18

(45) Publication of the grant of the patent:
24.08.88 Bulletin 88/34

(84) Designated Contracting States:
CH DE FR GB LI NL

(56) References cited:
US - A - 3 853 633

IEEE Spectrum, vol. 20, no. 10, October 1983 (New York, US), R.D. Davies: "The case for CMOS", pp. 26-32
Electronics International, vol. 56, no. 15, July 1983 (New York, US), M.A. Harris. "Scaled-down C-MOS may catapult GE to chip forefront", pp. 47-48
Electronics International, vol. 54, no. 20, October 1981 (New York, US), F. Lee et al.: "Cool-running 16-K RAM rivals N-channel MOS performance", pp. 120-123
International Electron Devices Meeting, Technical Digest, 13-15 December 1982 (San Francisco, US) L.C. Parrillo et al.: "Twin-tub CMOS II - an advanced VLSI technology", paper 29.3, pages 706-709
Patents Abstracts of Japan, vol. 5, no. 167 (E-79)(839), 24 october 1981; & JP-A-56 94 670

(73) Proprietor: Hughes Aircraft Company, 7200 Hughes Terrace P.O. Box 45066, Los Angeles California 90045-0066 (US)

(72) Inventor: LEE, William, W., 20052 Sea Gull Way, Saratoga, CA 95070 (US)
Inventor: CHANG, Kuang-Yeh, 248 Bacigalupi Drive, Los Gatos, CA 95030 (US)

(74) Representative: Colgan, Stephen James et al, CARPMAELS & RANSFORD 43 Bloomsbury Square, London WC1A 2RA. (GB)

(56) References cited: (continuation)
Patents Abstracts of Japan, vol. 8, no. 119, (E-248)(1556), 5 June 1984 & JP-A-59 32 163
Patents Abstracts of Japan, vol. 6, no. 136 (E120)(1014), 23 July 1982; & JP-A-57 62 565

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The disclosed invention relates to complementary metal oxide semiconductor (CMOS) integrated circuit structures, and is particularly directed to a latch-up resistant CMOS integrated circuit.

Monolithic CMOS integrated circuits are well known and include a plurality of N-channel and P-channel metal oxide semiconductor (MOS) transistors formed in a common silicon substrate. The major advantages of CMOS technology include low power dissipation, high noise immunity, a large supply voltage tolerance, symmetrical switching characteristics, and ease of circuit design. Despite such advantages, CMOS technology was not generally utilized until recently for very-large-scale-integration (VLSI) designs since the CMOS process technology is complex and expensive. However, with the continuous reduction in device (e.g. transistor) size and the advent of the VLSI era, CMOS technology has become a significant choice for VLSI designs, where perhaps the most important advantage of CMOS technology, is low power consumption, since heat generation becomes a more significant factor as device density increases. Another advantage of CMOS technology is ease of circuit design.

As packing density increases in CMOS integrated circuits, a well-known phenomenon known as latch-up is more likely to occur. Latch-up occurs when a pair of parasitic bipolar transistors formed by adjacent N-channel and P-channel devices become uncontrollably conductive. Effectively, a silicon-controlled rectifier (SCR) is formed by the parasitic transistors and may be triggered, for example, by excessive input voltages.

The phenomenon of latch-up is analyzed in the articles «A Better Understanding of CMOS Latch-up», G.J.Hu, IEEE Transactions On Electron Devices, Vol. Ed-31, No. 1, January 1984, pp.62–67; and «Latchup Model for the Parasite p-n-p-n Path in Bulk CMOS», R.C.Fang and J.L.Moll, IEEE Transactions On Electron Devices, Vol. ED-31, No. 1, January 1984, pp.113–120.

Present techniques for avoiding latch-up include the use of guard rings, which are heavily doped areas around each device. However, guard rings take up valuable chip area and thereby reduce packing density.

Another latch-up prevention structure is set forth in U.S. Patent 4172767 issued on November 6, 1979 to Stevenson and assigned to Hughes Aircraft Company. The Stevenson structure utilizes an additional region between complementary transistors, wherein the additional region is of a type opposite the type of the substrate material. Specifically, the additional region includes a heavily doped channel portion near the surface and lightly doped channel portion which extends downwardly from the heavily doped channel portion. However, it appears that the additional doped region would limit device packing density and would involve additional complex fabrication processes.

A presently proposed technique for latch-up prevention is the use of deep but narrow grooves to physically isolate the transistor devices. A depth of 5 to 7 micrometers is believed to be required while width should be maintained at 1 to 1.5 micrometers. This technique is discussed in an article «The Case for CMOS», R.D.Davies, IEEE Spectrum (October 1983), Vol. 20, No. 10, pp 26–32. However, deep narrow groove isolation presents processing difficulties, which apparently have not yet been overcome. To the extent that narrow groove isolation may be capable of being achieved, it is believed that unacceptable structural instabilities may exist. Moreover, deep narrow groove isolation causes device sidewall leakages and limits utilization design flexibility. Further, while deep groove isolation reduces the probability of latch-up, it does not eliminate it. Deep narrow groove isolation has not been shown to be commercially practical.

The above-referenced Davies article also discusses a retrograde well, wherein the peak well-dopant concentration is below the substrate surface, as another proposed formation for helping to suppress latch-up. However, the article points out that the latch-up suppression of retrograding apparently has not been achieved in practice since a sufficiently small surface dopant concentration relative to the peak concentration has not yet been achieved.

An article by M.A.Harris in Electronics International, Vol. 56 (1983), No. 15, pages 47–48, mentions further the use of retrograde wells in the formation of CMOS structures.

JP-A-5932163 discloses a similar structure to that described in the above-mentioned Davies article. However, the structure in the Japanese document incorporates a trench filled with field oxide rather than a narrow groove.

According to the present invention there is provided a complementary metal oxide semiconductor (CMOS) structure comprising:
a common lightly doped substrate (11);
a n-channel transistor (13) formed in a p-well (21) formed in the substrate (11);
a p-channel transistor (15) foremed in a n-well (33) formed in the substrate (11); and
a trench (17) filled with field oxide (19) extending between the transistors (13, 15) of opposite type,
wherein the p-well (21) and the n-well (33) are each provided with a retrograde impurity concentration profile in which the peak impurity concentration is substantially below the substrate surface, characterised in that:
the p-well (21) extends beneath the trench (17);
the n-well (33) extends beneath the trench (17);
the retrograde impurity concentration profiles of the respective p and n-wells extend beneath the trench (17); and
heavily doped field-regions (45, 47) of opposite conductivity type and adjacent one another are formed in the common substrate beneath the field oxide (19).

The advantages and features of the invention will be readily understood by persons skilled in the art from the following detailed description when read in conjunction with the drawing wherein:

Fig. 1 is a partial cross-sectional schematic of the CMOS structure of the invention;

fig. 2 is a top plan view of a portion of the disclosed CMOS structure;

fig. 3 is a schematic diagram of an equivalent circuit of the parasitic transistors in the CMOS structure shown in fig. 1 and 2.

In the following description and in the several figures of the drawing, like elements are identified with like reference numerals.

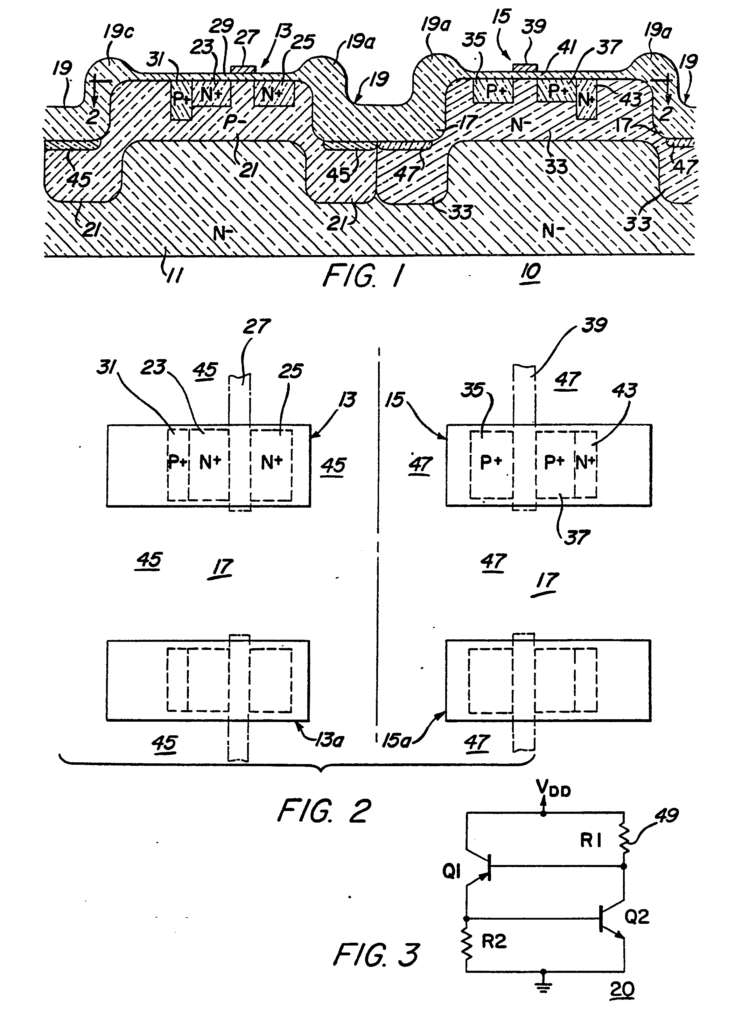

Referring now to fig. 1, shown therein is a cross-sectional schematic of a two transistor section 10 of an integrated circuit which includes a common substrate 11 that is a lightly doped N-type material. N-channel and P-channel transistor devices are formed on the common substrate 11, and the two transistor section 10 includes an N-channel transistor 13 and a P-channel transistor 15. Between each of the transistors of the integrated circuit is a trench, as is shown by the trenches 17.

Referring to fig. 2, shown therein are the N-channel transistor 13 and the P-channel transistor 15, along with another N-channel transistor 13a and another P-channel transistor 15a. Fig. 2 schematically depicts the trenches between the individual transistor devices.

By way of example, the trenches 17 between devices of opposite type, such as the transistors 13 and 15 may be about .9 microns deep and about 4 microns wide. Between devices of the same type, such as the transistors 13 and 13a shown in fig. 2, the trenches 17 may be about .9 microns deep and about 2 to 4 microns wide. The trenches 17 are filled partially with field oxide 19.

The N-channel transistor 13 ist formed in a P-well 21 formed in the substrate 11. The P-well 21 has a retrograde impurity concentration profile wherein the peak impurity concentration is substantially below the substrate surface, instead of at the surface. For example, the peak concentration may be about 1 micron below the substrate surface. The P-well 21 extends beneath adjacent trenches 17 and extends further downwardly into the substrate 11 beneath the trenches 17. Beneath the trench regions the peak impurity concentration would, for example, also be about 1 micron below the substrate surface in the trench regions.

The N-channel transistor 13 includes an N-type source region 23 and an N-type drain region 25. The source region 23 and drain region 25 are relatively shallow and are separated from the peak impurity concentration of the P-well 21 as a result of the retrograde impurity concentration profile. By way of example, the source and drain regions may have depths of about onefourth of a micron. A polycrystalline silicon (polysilicon) gate 27 is located above the P-well portion between the source region 23 and the drain region 25, and is isolated by a gate oxide layer 29. The gate oxide layer 29 merges into the field oxide 19 in the trenches 17, and a «bird's beak» 19a is formed.

A heavily doped P-type region 31 is formed in the P-well 21 to provide a contact for the P-well 21 which is typically connected to ground (connection not shown). The P-type region 31 is usually contiguous to the source region 23. In practice, the source region 23 and the P-type region 31 are shorted by a metallic contact which straddles both regions.

Appropriate contact openings, not shown, are provided in the gate oxide layer 29 for the source region 23, the drain region 25, and the P-well contact region 31.

The P-channel transistor 15 is formed in an N-well 33 formed in the substrate 11. The N-well 33 has a retrograde impurity concentration wherein the peak impurity concentration is substantially below the substrate surface, instead of at the surface. The N-well 33 extends beneath adjacent trenches 17 and extends further downwardly into the substrate 11 beneath the trenches 17. By way of example, the peak impurity concentration is about 1 micron relative to the top surfaces of the substrate 11.

The P-channel transistor 15 includes a P-type drain region 35 and a P-type source region 37. The drain region 35 and source region 37 are substantially separated from the peak impurity concentration of the N-well 33 as a result of the retrograde impurity concentration profile. By way of example, the source and drain regions have depths of about one-fourth of a micron. A polysilicon gate 39 is located above the N-well portion between the drain region 35 and the source region 37, and is isolated by a gate oxide layer 41. The gate oxide layer 41 merges into the field oxide 19 in the trenches 17, and a «bird's beak» 19a is formed.

A heavily doped N-type region 43 is formed in the N-well 33 to provide a contact for the N-well 33 which is generally connected to the supply voltage (connection not shown). The N-type region 43 is usually contiguous to the source region 37. In practice, the source region 37 and the N-type region 43 are shorted by a metallic contact which straddles both regions.

Appropriate contact openings, not shown, are provided in the gate oxide layer 41 for the drain region 35, the source region 37, and the N-well contact region 43.

A heavily doped P-type field region 45 surrounds the P-well 21, and a heavily doped N-type field region 47 surrounds the N-well 33. The heavily doped P type region 31, which provides a contact for the P-well 21, is adjacent and very close to the field region 45. The heavily doped N-type region 43, which provides a contact for the N-well 33, is adjacent and very close to the field region 47. The field regions 45 and 47 are highly conductive layers which tend to prevent field inversion and aid in preventing latch-up.

The field regions 45 and 47 are of opposite type and are adjacent one another in the trenches 17 separating devices of opposite type, such as the transistors 13 and 15. In the trenches 17 separating devices of the same type, such as the transistors 13 and 13a shown in in fig. 2, a field region of one type would extend between the sides of the trenches. Specifically, between the transistors 13 and 13a, a heavily doped P-type field region is provided.

The various N-type and P-type regions in the two transistor section 10 (fig. 1 and 2), and the typical connections to supply voltage and ground (discussed above) cooperate to promote unwanted bipolar transistor conduction. Such bipolar transistor conduction is illustrated by the equivalent circuit 20 shown in fig. 3, which will also be discussed in connection with the latch-up suppression advantages of the disclosed CMOS structure.

The equivalent circuit 20 includes a resistor R1 which is connected between the supply voltage, identified as $V_{DD}$, and the base of a PNP transistor Q1. A resistor R2 is connected between the base of an NPN transistor Q2 and ground. The collector of the PNP transistor Q1 is coupled to the supply voltage $V_{DD}$, and the emitter of the PNP transistor Q1 is connected to the base of the NPN transistor Q2. The collector of the NPN transistor Q2 is coupled to the node formed by one end of the resistor R1 and the base of the PNP transistor Q1. The emitter of the NPN transistor Q2 is connected to ground.

In the equivalent circuit 20, the resistor R1 represents the resistance of the N-well 33 and the substrate 11. The resistor R2 represents the resistance of the P-well 21. The source region 37 of the P-channel transistor 15 forms the emitter of the PNP transistor Q1; the N-well 33 and the substrate 11 form the base of Q1; and the P-well 21 forms the collector of Q1. The source region 23 of the N-channel transistor 13 forms the emitter of the NPN transistor Q2; the P-well 21 forms the base of Q2; and the N-well 33 and the substrate 11 form the collector of Q2.

In order for latch-up to occur, the base-emitter junctions of the transistors Q1 and Q2 must be forward biased, and the product of the current gains of the transistors Q1 and Q2 must be one or greater.

In the disclosed CMOS structure, the effective resistance values for R1 and R2 are reduced by the field regions 45 and 47. More importantly, the current gains of transistors Q1 and Q2 are substantially reduced since (1) the retrograde impurity profiles of the N- and P-wells present doping impurity concentration gradients which create retarding fields; and (2) the N- and P-well formations extend under and downwardly beneath the trenches 17. The built-in field due to the impurity concentration gradient enhances the collection of any minority carriers before such minority carriers can forward bias any junctions.

The above-described structure is fabricated in a lightly doped N-type 20 ohm-cm silicon substrate or wafer. A thermal oxide layer having a thickness of about 300 Angstroms is grown on the silicon substrate, which is followed by a deposition of a silicon nitride layer having a thickness of about 1500 Angstroms. Photoresist is then applied and exposed with an appropriate mask to define a photoresist mask to protect the active areas. Planar plasma etching is utilized to etch the nitride layer between the active areas (i.e., to etch nitride layer over the substrate regions where trenches will be formed). The wafer is then dipped in buffered hydrofluoric (HF) acid to dissolve the unprotected oxide layer between the active areas.

At this point, the active areas are protected by the photoresist mask and the substrate regions between the active areas are unprotected. The trenches are formed in such unprotected regions by plasma etching using a planar plasma machine. The trenches are etched to a depth of about 6000 Angstroms relative to the top of the substrate in the active areas.

To form the P-wells, photoresist is applied, exposed and developed to provide a photoresist mask to cover and protect the P-channel device areas and the associated well and field regions (i.e., the N-well region 33 and the field regions 47 shown in fig. 1 and 2). High energy boron having a projected ion implantation range ($R_p$) of greater than 5000 Angstroms is implanted for a dose of about $10^{13}/cm^2$. The high energy boron penetrates the oxide and nitride layers to form the P-wells which extend to a depth about 2.0 microns relative to the upper surfaces of the silicon substrate. The P-well regions are also formed deeper under the trench regions, as shown in fig. 1 with respect to the P-well 21.

The wafer is subsequently implanted with boron at about 15 KeV and a dosage of about $10^{15}/cm^2$. This implant does not penetrate the active regions which are protected by the oxide and nitride layers, but forms the highly conductive P-type field regions, as shown in fig. 1 with respect to the P-type field regions 45.

Next, an aluminium layer having a thickness of about 1 micron is deposited. The photoresist layer is then lifted, leaving the aluminium layer as a mask over the P-well regions. The N-well regions are then processed in a manner similar to the processes for the P-well regions. Specifically, phosphorous is implanted at high energy to form the N-wells which extend beneath the trenches. The highly conductive N-type field regions are formed by implantation of low energy phosphorous which does not penetrate the active areas which are protected by the oxide and nitride layers. The dosage of the phosphorous field implant can be adjusted to obtain the desired zener breakdown voltage between the N-type field region and the P-type region.

The foregoing described processes utilize a single P-well mask to form P-well regions and the highly conductive P-type field regions for the N-channel devices. A single N-well mask is utilized to form the N-well regions and the highly conductive N-type field regions for the P-channel devices. The lift-off technique provides for self-alignment between the respective P-well (for N-channel devices) and N-well (for P-channel devices) masks, which is accomplished with a single photoresist procedure. Such self-alignment is believed to provide high device density and high yields.

After the well and field regions are formed, the aluminium mask layer is stripped off, and field oxide is grown at low temperature in steam. The field oxide is grown to provide a thickness of about 6000 Angstroms in the trench regions.

With the foregoing fabrication process, the field regions 45 and 47 are separated from the active regions in a self-aligned manner, and are specifically separated from the source and drain regions by the trenches 17 and the bird's beak 19a. Therefore, the field regions 45 and 47 can be heavily doped without running the risk of low avalanche breakdown voltage of the diode formed by a drain region and a respective well. The high conductivity associated with such heavy doping decreases the positive feedback action necessary for latch-up, and also increases the radiation hardness of the field regions.

Conventional processing is then utilized to provide the gate contacts, source and drain implants, and appropriate contacts.

It should be noted that in the foregoing described integrated circuit structure and process, it is not necessary that the retrograde impurity concentration profile go to zero at the surface of the substrate 11. The retrograde impurity profile cooperates with other aspects of the integrated circuit to prevent latch-up. Specifically, the retrograde impurity concentration profile presents a concentration gradient which tends to enhance minority carrier recombination. The wells which extend beneath the trenches provide a higher number of majority type carriers, thus providing for increased recombination. The longer paths for conduction imposed by the trenches and the deeper N- and P-wells also provide for increased recombination. Thus, since minority carrier current is mostly collected in the base regions of the parasitic bipolar transistors, the betas of the parasitic bipolar transistors are substantially reduced, thereby preventing latch-up.

The disclosed structure has further advantageous features. The retrograde impurity concentration profiles of the respective P- and N-wells extend beneath the trenches 17, thereby providing built-in fields which tend to sweep any stray minority carriers toward the interface between the substrate 11 and the field oxide 19, to be collected by the heavily doped field regions 45 and 47. Also, the proximity of the doped regions 31 and 43, which provide respective well contacts, to the field regions 45 and 47, respectively allow for low resistance paths between the doped region 31 and the field region 45, and between doped region 43 and the field region 47. The significance of the low resistance paths thus provided is best understood with reference to the Fang and Moll article previously cited. The authors of that article concluded that when the doped regions provided as tiedown contacts are placed close to the well boundaries, most of the injected base current would not contribute to forward biasing a junction, thereby resulting in a much larger holding current required to sustain latch-up. In the disclosed invention, the doped regions 31 and 43 provided for tie-down contacts are coupled to the field regions 45 and 47 by very low resistance paths. The doped regions 31 and 35 thereby provide the same effect as if they were located at the boundaries of the wells since the field regions 45 and 47 are at the well boundaries. Thus, the disclosed field regions and well regions tend to prevent latch-up.

The disclosed integrated circuit is latch-up resistant and, therefore, allows for smaller transistor devices and denser device packing while maintaining high yields. Such reductions in scale result in faster speeds since CMOS devices are basically surface field devices.

A further benefit of the disclosed integrated circuit structure is an increased source-drain breakdown voltage since (1) deep well impurity concentration peaks improve source/drain punch through, and (2) the source and drain regions are substantially separated from the heavily doped field regions.

Another way of understanding the disclosed integrated circuit is to consider the individual devices as being formed in individual mesas. Such mesas provide some degree of isolation between the individual transistor devices. Isolation is further accomplished by the well formations, the well retrograde profile, and the highly doped field regions.

## Claims

1. A complementary metal oxide semiconductor (CMOS) structure comprising:
   a common lightly doped substrate (11);
   a n-channel transistor (13) formed in a p-well (21) formed in the substrate (11);
   a p-channel transistor (15) formed in a n-well (33) formed in the substrate (11); and
   a trench (17) filled with field oxide (19) extending between the transistors (13, 15) of opposite type,
   wherein the p-well (21) and the n-well (33) are each provided with a retrograde impurity concentration profile in which the peak impurity concentration is substantially below the substrate surface, characterised in that:
   the p-well (21) extends beneath the trench (17);
   the n-well (33) extends beneath the trench (17);
   the retrograde impurity concentration profiles of the respective p and n-wells extend beneath the trench (17); and
   heavily doped field-regions (45, 47) of opposite conductivity type and adjacent one another are formed in the common substrate beneath the field oxide (19).

2. A structure according to claim 1 wherein the common substrate (11) is a n-type material.

3. A structure according to claim 1 wherein the common substrate (11) is a p-type material.

4. A structure according to any preceding claim in which a heavily doped p-type region (31) is formed in the p-well (21) to provide a contact for the p-well (21).

5. A structure according to any preceding claim in which a heavily doped n-type region (43) is formed in the n-well (33) to provide a contact for the n-well (33).

**Patentansprüche**

1. Komplementäre metall-oxid-halbleiter-(CMOS) Struktur, welche aufweist:
ein gemeinsames gering dotiertes Substrat (11); einen n-Kanal Transistor (13), welcher in einer p-Wanne (21) gebildet ist, welche in dem Substrat (11) gebildet ist;
einen p-Kanal Transistor (15), welcher in einer n-Wanne (33) gebildet ist, welche in dem Substrat (11) gebildet ist; und
einen Graben (17), welcher mit Feld-Oxid (19) gefüllt ist, welcher sich zwischen die Transistoren (13, 15) von gegensätzlichem Typ erstreckt,
wobei die p-Wanne (21) und die n-Wanne (33) jeder mit einem rückläufigen Verunreinigungskonzentrationsprofil ausgestattet sind, in welchem die Spitzenverunreinigungskonzentration im wesentlichen unter der Substratoberfläche ist, dadurch gekennzeichnet, dass:
die p-Wanne (21) sich unterhalb des Grabens (17) erstreckt;
die n-Wanne (33) sich unterhalb des Grabens (17) erstreckt;
das rückläufige Verunreinigungskonzentrationsprofil der entsprechenden p- bzw. n-Wanne sich unterhalb des Grabens (17) erstreckt; und
stark dotierte Feldbereiche (45, 47) von entgegengesetztem Leitfähigkeitstyp zueinander benachbart und in dem gemeinsamen Substrat unterhalb des Feldoxids (19) gebildet sind.

2. Struktur nach Anspruch 1, wobei das gemeinsame Substrat (11) n-Typ Material ist.

3. Struktur nach Anspruch 1, wobei das gemeinsame Substrat (11) p-Typ Material ist.

4. Struktur nach einem der vorhergehenden Ansprüche, in der ein stark dotierter p-Typ Bereich (31) in der p-Wanne (21) gebildet ist, um einen Kontakt für die p-Wanne (21) zu bilden.

5. Struktur nach einem der vorhergehenden Ansprüche, in der ein stark dotierter n-Typ Bereich (43) in der n-Wanne (33) gebildet ist, um einen Kontakt für die n-Wanne (33) zu bilden.

**Revendications**

1. Structure semi-conductrice métal-oxyde complémentaire (CMOS) comprenant:
un substrat commun faiblement dopé (11);
un transistor de canal n (13) formé dans un puits p (21) formé dans le substrat (11);
un transistor de canal p (15) formé dans un puits n (33) formé dans le substrat (11);
et une tranchée (17) remplie avec un oxyde de champ (19) s'étendant entre les transistors (13, 15) de type opposé,
dans laquelle le puits p (21) et le puits n (33) sont tous deux munis d'un profil de concentration en impuretés rétrograde dans lequel la concentration crête en impuretés est sensiblement sous la surface du substrat, caractérisée en ce que:
le puits p (21) s'étend sous la tranchée (17);
le puits n (33) s'étend sous la tranchée (17);
les profils de concentration en impuretés rétrogrades des puits respectifs p et n s'étendent sous la tranchée (17); et
des régions de champ fortement dopées (45, 47) de conductivité opposée et adjacentes l'une à l'autre sont formées dans le substrat commun sous l'oxyde de champ (19).

2. Structure conforme à la revendication 1 dans laquelle le substrat commun (11) est un matériau de type n.

3. Structure conforme à la revendication 1 dans laquelle le substrat commun (11) est un matériau de type p.

4. Structure conforme à toute revendication précédente dans laquelle une région (31) de type p fortement dopée est formée dans le puits p (21) pour fournir un contact pour le puits p (21).

5. Structure conforme à l'une des revendications précédentes dans laquelle une région (43) de type n fortement dopée est formée dans le puits n (33) pour fournir un contact pour le puits n (33).

FIG. 1

FIG. 2

FIG. 3